(19) Europäisches Patentamt
European Patent Office
Office européen des brevets

(11) **EP 4 335 630 A1**

(12) **EUROPEAN PATENT APPLICATION**

(43) Date of publication:
**13.03.2024 Bulletin 2024/11**

(21) Application number: **22306329.8**

(22) Date of filing: **07.09.2022**

(51) International Patent Classification (IPC):
**B29D 11/00** (2006.01)    **G03F 7/18** (2006.01)
**G03F 7/24** (2006.01)    **G03F 7/20** (2006.01)

(52) Cooperative Patent Classification (CPC):
**B29D 11/00326; B29D 11/00009; B29D 11/0048;
G03F 7/18; G03F 7/24; G03F 7/70283;
G03F 7/70416**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Essilor International
94220 Charenton-Le-Pont (FR)**

(72) Inventor: **CHIU, Hao-Wen
DALLAS, 75234 (US)**

(74) Representative: **Plasseraud IP
66, rue de la Chaussée d'Antin
75440 Paris Cedex 09 (FR)**

(54) **METHOD FOR PATTERNING A MASK, METHOD FOR PRODUCING AN INSERT OR A MOLD, AND OPTICAL ARTICLE WITH SURFACE MICROSTRUCTURES**

(57)    The disclosure relates to a method for preparing an object having a curved surface to be etched, the resulting etched surface being useable as a mold for manufacturing an optical article. The method comprises illuminating the curved surface of the object through a patterned mask placed over or on the curved surface. The patterned mask comprises a curved surface that is configured to conform to the curved surface of the object. The curved surface of the patterned mask comprises at least one micrometer-sized area that differs in transmission function from an adjacent area. The curved surface is made of a material which, when thusly illuminated, undergoes local changes in a chemical resistance to a developer.

The disclosure further relates to a method for patterning a mask having a curved surface and to an optical article having a curved surface comprising microstructures that are uniformly normal to the curved surface.

FIG. 14

EP 4 335 630 A1

**Description**

FIELD OF THE INVENTION

The present invention relates to the field of ophthalmic optics.

More particularly, the present invention relates to a method for patterning a mask having a curved surface, to a method for preparing an object having a curved surface to be etched and to an optical article having a curved surface.

BACKGROUND OF THE INVENTION

Myopia has become a major public health problem in the world due to the increase in its prevalence in the past few decades. In recent years, various options have been assessed to prevent or reduce myopia progression in children.

One of these options is the daily use of corrective spectacle lenses that also slow down myopia progression due to exhibiting a specific arrangement of surface microstructures.

Stellest™ lenses are an example of polycarbonate unifocal lenses comprising a spherical front surface with an arrangement of aspherical lenslets. These lenses may be successfully manufactured by injection molding using concave Nickel-Phosphorus plated steel inserts with microstructures by diamond-turning.

However, fabrication of such steel inserts is very costly. Besides, only limited types of microstructures can be generated by diamond turning. More economically feasible ways of making inserts or molds with surface microstructures for injection molding or casting are needed.

Further, glass inserts are required for injection molding to make minus finished single vision polycarbonate lenses free of defects such as weld lines and center distortion. A reason is the poor thermal conductivity of glass which, comparatively to steel inserts, slows down the cooling of molten polycarbonate. However, producing precise microstructures onto the surface of typical borosilicate glass is currently not possible. There is a need for a manufacturing process that is compatible with an insert material that has similar thermal behavior to borosilicate glass and that further allows easily forming microstructures on its surface.

SUMMARY OF THE INVENTION

The present invention has been made in consideration of the above problem.

According to a first aspect of the proposed technique, there is provided a method for patterning a mask having a curved surface by causing local variations of an optical property over the curved surface, wherein:

the method comprises illuminating selected micrometer-sized areas of the curved surface; and
the curved surface is made of a material which, when thusly illuminated, undergoes local transformations over the illuminated areas, the local transformations being related to the local variations of the optical property.

The first aspect of the proposed technique allows providing a curved patterned mask exhibiting local variations of an optical property, for instance transmission.

Further, since the transformations of the curved surface are local, over micrometer-sized areas, the first aspect of the proposed technique allows the patterned curved mask to significantly diffract visible light. This allows the patterned curved mask to be used as a grayscale curved mask for visible light by taking advantage of wave interference phenomena.

Optionally, illuminating the selected micrometer-sized areas of the curved surface comprises, for each selected micrometer-sized area, displacing the mask so that the selected micrometer-sized area is in a set X-Y-Z position and illuminating the set X-Y-Z position.

This allows a better control of the shapes of the illuminated areas regardless of their locations on the curved surface.

Optionally, the material of the curved surface is a photoresist.

A photoresist is a light-sensitive material. In the case of a positive photoresist, the photo-sensitive material is degraded by light. In the case of a negative photoresist, the photosensitive material is strengthened (either polymerized or cross-linked) by light.

Optionally, the method further comprises:

after illuminating the selected micrometer-sized areas of the curved surface, locally dissolving the material of the curved surface to locally reveal a coating, for example by applying a developer; and,
optionally, after locally dissolving the material of the curved surface, etching the revealed coating, for example by reactive ion etching.

In the case of a positive photoresist, the developer dissolves away the regions that were exposed to light. In the case of a negative photoresist, the developer dissolves away only the regions that were not exposed to light.

The coating is one or more layers or films that covers a substrate. The coating and the substrate have different optical properties.

Typically, the coating is opaque while the substrate is transparent. Some regions may then be made transparent by locally removing the coating while keeping the other regions opaque. The coating left behind the dissolved regions of the photoresist may be for instance a layer of chromium or a first layer of chromium oxide covering a second layer of chromium, in the case of a traditional chrome on glass mask. Various other types of coatings are however applicable.

Rather than the mask being formed by illuminating a photoresist covering a coated substrate, it is also possible to form the mask by illuminating certain types of substrates devoid of photoresist and coating.

In this regard, optionally, the material of the curved surface is a high energy beam sensitive (HEBS) glass.

For instance, some known HEBS-glasses may turn dark upon exposure to a high energy beam such as an electron beam or a laser beam.

Optionally, illuminating the selected micrometer-sized areas of the curved surface comprises illuminating a first selected micrometer-sized area with a first exposure dose and illuminating a second selected micrometer-sized area with a second exposure dose different from the first exposure dose.

Since the transparency of some known HEBS-glasses is a function of exposure dose, illuminating different micrometer-sized areas with different exposure doses allows providing a curved grayscale photomask by precisely controlling the transmittance of the curved mask over its curved surface with a resolution in the micrometer range.

According to a second aspect of the proposed technique, there is provided a method for preparing an object having a curved surface to be etched, the resulting etched surface being useable as a mold for manufacturing an optical article, wherein:

the method comprises illuminating the curved surface through a patterned mask placed over or on the curved surface;

the patterned mask comprises a curved surface that is configured to conform to the curved surface of the object;

the curved surface of the patterned mask comprises at least one micrometer-sized area that differs in transmission function from an adjacent area; and

the curved surface is made of a material which, when thusly illuminated, undergoes local changes in a chemical resistance to a developer.

Owing to its properties, the material forming the curved surface of the object is a photoresist, and the object is a stack comprising at least two layers: the photoresist and a substrate. The substrate may be made of any material that is physically and/or chemically etchable. This includes dielectric materials ($SiO_2$, Si3N4, etc.), silicon-based materials (Si, a-Si, poly-Si), III-V materials (GaAs, InP, GaN, etc.), and metals (Al, Cr, Ti, etc.). The substrate may be chosen for its thermal conductivity, which is preferably within two orders of magnitude as an intended material of an optical lens to be molded against the curved surface of the object once etched.

The curved surface of the patterned mask may comprise a plurality of micrometer-sized areas which each differ in transmission function from a corresponding adjacent area. A possible way of obtaining such patterned mask is by patterning a curved mask according to the first aspect of the proposed technique.

The second aspect of the proposed technique allows generating a rich variety of microstructures on a curved surface of an object. The object may then be used as an insert or as a mold for, respectively, injection molding or casting optical lenses having surface microstructures.

Owing to the mask having a curved surface conforming to the curved surface of the object, the resulting insert or mold further allows achieving weld-line free finished single vision polycarbonate lenses with surface microstructures that are geometrically uniform and structurally normal to the curved surface. The resulting insert or mold may further be used as a master for creating a microstructured stamp for imprinting.

Optionally, the patterned mask is a binary mask, for example a chrome on glass binary mask.

A binary mask is here understood in a literal sense, as being for instance a mask having at least one opaque micrometer-sized area adjacent to a transparent area, or at least one transparent micrometer-sized area adjacent to an opaque area.

The patterned mask may also be an alternating phase-shift mask or an attenuated phase-shift mask, both of these possible implementations being analogous to a binary mask.

Since the considered area/s is/are micrometer-sized, and since in common lithography systems the light source illuminating a mask usually emits ultraviolet light at 248 nm and 193 nm wavelengths, the binary mask is functionally a grayscale mask due to diffraction at the considered areas.

Optionally, the curved surface of the binary mask comprises a plurality of micrometer-sized areas that differ in transmission function from an adjacent area, said micrometer-sized areas being arranged according to a pattern comprising a first region with a first density of said micrometer-sized areas and a second region with a second density of said micrometer-sized areas different from the first density.

Optionally, the patterned mask is a gray-scale mask, for example a gray-scale high energy beam sensitive glass mask.

This means that the curved surface of the patterned mask is not simply opaque over some areas and transparent elsewhere, but has a transmission value that varies continuously or in a ramped manner between one or more intermediate levels between a minimum value corresponding to a most opaque area and a maximum value corresponding to a most transparent area.

Optionally, the curved surface of the gray-scale mask comprises a first region with a first transmittance and a second region with a second transmittance different from the first transmittance.

Optionally, illuminating the curved surface of the object through the patterned mask comprises:

> illuminating a first region of the curved surface of the object through the first region of the curved surface of the patterned mask, so that the first region of the curved surface of the object receives a first exposure dose; and
>
> illuminating a second region of the curved surface of the object through the second region of the curved surface of the patterned mask, so that the second region of the curved surface of the object receives a second exposure dose different from the first exposure dose.

In an example, one among the first and the second exposure doses is different from zero while the other is equal to zero. As a result, the curved surface of the object may have microstructures only on regions illuminated through a single region of the pattern among the first region and the second region.

According to a third aspect of the proposed technique, there is provided an optical article having a curved surface comprising microstructures; wherein the microstructures are uniformly normal to the curved surface.

Optionally, the optical article is for use in slowing down myopia progression.

When surface microstructures are specified as part of an optical design of an optical article, their specified orientation is, usually, normal to the surface where the microstructures are formed. It is desirable, for various purposes among which optical quality, that the microstructures actually formed on the surface of the optical article are as close as possible to their specified orientation.

In particular, it is known that some arrangements of microstructures on the surface of an optical article inherently contribute to slowing down myopia progression when the optical article is worn, due to purposely forming a partially blurred image on the retina of the wearer. It is paramount that the orientation of the microstructures is accurately controlled in order for the optical article to form, when worn, the partially blurred image as desired on the retina of the wearer.

Optionally, the optical article is weld-line free and/or free of other types of defects such as center distortion defects. Both types of defects are known and well-described in the art.

Weld lines are defects occurring when molding an optical article if the material of the optical article has a thermal conductivity that largely differs from that of the mold. In general, weld lines can be formed during injection when an advancing polymer melt front meets another melt front, which can originate from filling a cavity of the mold from multiple gates. As such, this can lead to head-on impingement of separate flow fronts of the polymer melt, or splitting and converging of flow fronts due to presence of obstacles or excess transversal part thickness variation.

Optionally, the optical article may be in organic glass, for instance in polycarbonate, isosorbide polycarbonate, polymethylmethacrylate, polyamide, copolyester, thermoplastic polyurethane, polysulfone, polyphenylsulfone, or cyclic olefin copolymer. Polycarbonate has a thermal conductivity of 0.2 $W.m^{-1}.K^{-1}$. Polymethylmethacrylate has a thermal conductivity of 0.18 $W.m^{-1}.K^{-1}$. Polyamide has a thermal conductivity of 0.2 $W.m^{-1}.K^{-1}$. Polyphenylsulfone has a thermal conductivity of 0.35 $W.m^{-1}.K^{-1}$. Cyclic olefin copolymer has a thermal conductivity of 0.16 $W.m^{-1}.K^{-1}$.

Further considering the underlying cause for weld-lines as mentioned above, in the method according to the second aspect, the resulting etched surface may be in a material having a thermal conductivity greater than 0.02 $W.m^{-1}.K^{-1}$, preferably greater than 0.1 $W.m^{-1}.K^{-1}$, and smaller than 50 $W.m^{-1}.K^{-1}$, preferably smaller than 25 $W.m^{-1}.K^{-1}$.

BRIEF DESCRIPTION OF THE DRAWINGS

For a more complete understanding of the description provided herein and the advantages thereof, reference is now made to the brief descriptions below, taken in connection with the accompanying drawings and detailed description, wherein like reference numerals represent like parts.

FIG. 1A - 1F illustrate schematically a photolithography process to generate rectangular microstructures on a substrate.

FIG. 2A - 2D illustrate schematically a grayscale lithography process to generate a gradient microstructure on a substrate.

FIG. 3 illustrates schematically a chrome on glass mask patterned with opaque pixels.

FIG. 4 illustrates schematically an intensity profile of a pattern obtained by single-slit diffraction.

FIG. 5A - 5C illustrate schematically intensity profiles of patterns obtained by diffraction from different possible patterned masks.

FIG. 6 illustrates schematically a result of a photolithography process.

FIG. 7 and FIG. 8 illustrate exemplary results of a photolithography process.

FIG. 9A - 9D illustrate schematically a chrome on glass photomask fabrication process.

FIG. 10 illustrates schematically an electron beam lithography system.

FIG. 11 illustrates a surface comprising 2 μm concentric lines, as obtained by electron beam lithography.

FIG. 12A - 12D illustrate schematically a glass prism array obtained by a grayscale lithography process with a high energy beam sensitive glass mask.

FIG. 13A and 13B illustrate schematically a 600 nm Fresnel lens obtained by a grayscale lithography process

FIG. 14 illustrates schematically a method for producing an insert according to an embodiment of the invention.

FIG. 15 illustrates schematically a microlens array on a polycarbonate lens and a corresponding microlens array on an insert made of fused silica bonded to stainless steel, the insert having been used to obtain the polycarbonate lens by injection molding.

## DETAILED DESCRIPTION OF THE INVENTION

The proposed technique aims at producing inserts for thermoplastic injection molding or molds for thermoset casting of lenses with surface microstructures. More precisely, the proposed technique aims at fabricating inserts or molds from silicon wafer or photosensitive or photo-structural glass (PSG) using very mature wafer-based semiconductor manufacturing technologies. An added benefit of such inserts is the ability to produce weld-line free finished single vision polycarbonate lenses with surface microstructures, owing to the low thermal conductivity of the insert material.

The proposed technique allows forming surface microstructures which precisely extend over specific micrometer-sized areas of a curved surface of the insert or mold. As will be detailed, it is relied on the use of a curved mask to precisely illuminate the micrometer-sized areas, in view of forming the surface microstructures by etching.

Patterning curved masks is a challenge itself and a patterning technique is also proposed.

Definitions are now proposed for a variety of terms and expressions used herein.

A curved surface of a mask, object, or optical article is the opposite of a flat surface. A curved surface may be spherical, aspherical or cylindrical. A curved surface of a mold or insert has the same shape and size as a curved front or back surface of an ophthalmic optical lens to be manufactured by molding with such insert.

Surface microstructures are microlenses or microlenslets or any other type of structure or elements having physical Z deformation/height or depth between 0.1 μm to 50 μm and width/length between 0.5 μm to 1.5 mm. Z deformation/height indicate a local deviation from an otherwise spherical, aspherical or cylindrical shape of a curved surface. These structures preferably have periodical or pseudo periodical layout, but may also have randomized positions. The preferred layout for microstructures is a grid with constant grid step, honeycomb layout, multiple concentric rings, contiguous e.g. no space in between microstructures. These structures may provide optical wave front modification in intensity, curvature, or light deviation, where the intensity of wave front is configured such that structures may be absorptive and may locally absorb wave front intensity with a range from 0% to 100%, where the curvature is configured such that the structure may locally modify wave front curvature with a range of +/- 20 Diopters, and light deviation is configured such that the structure may locally scatter light with angle ranging from +/- 1° to +/- 30°. A distance between structures may range from 0 (contiguous) to 3 times the structure in "X" and/or "Y" size (separate microstructures).

Furthermore, microstructures which form a microstructured main surface of an ophthalmic lens substrate may include lenslets. Lenslets may form bumps and/or cavities (i.e., raised or recessed lenslet structures) at the main surface they are arranged onto. The outline of the lenslets may be round or polygonal, for example hexagonal. More particularly, lenslets may be microlenses. A microlens may be spherical, toric, cylindrical, prismatic, or aspherical shapes or any combination to make a multi-element shape. A microlens may have a single focus point, or cylindrical power, or multi-focal power, or non-focusing point. Microlenses can be used to prevent progression of myopia or hyperopia. In that case, the base lens substrate comprises a base lens providing an optical power for correcting myopia or hyperopia, and the microlenses may provide respectively an optical power greater than the optical power of the base lens if the wearer has myopia, or an optical power lower than the optical power of the base lens if the wearer has hyperopia. Lenslets may also be Fresnel structures, diffractive structures such as microlenses defining each a Fresnel structure, permanent technical bumps (raised structures), or phase-shifting elements. It can also be a refractive optical element such as microprisms and a light-diffusing optical element such as small protuberances or cavities, or any type of element generating roughness on the substrate. It can also be π-Fresnel lenslets as described in US2021109379, i.e. Fresnel lenslets which phase function has π phase jumps at the nominal wavelength, as opposition to unifocal Fresnel lenses which phase jumps are multiple values of 2π. Such lenslets include structures that have a discontinuous shape. In other words, the shape of such structures may be described by an altitude function, in terms of distance from the base level of the main surface of the optical lens the lenslet belongs to, which exhibits a discontinuity, or which derivative exhibits a discontinuity. In a useful scope, the microstructure can be a branding mark, holographic mark, metasurface, or the like.

Lenslets may have a contour shape being inscribable in a circle having a diameter greater than or equal to 0.5 micrometers ($\mu$m) and smaller than or equal to 1.5 millimeters (mm). Lenslets may have a height, measured in a direction perpendicular to the main surface they are arranged onto, that is greater than or equal to 0.1 $\mu$m and less than or equal to 50 $\mu$m. Lenslets may have periodical or pseudo periodical layout but may also have randomized positions. One layout for lenslets is a grid with constant grid step, honeycomb layout, multiple concentric rings, contiguous e.g. no space in between microstructures. These structures may provide optical wave front modification in intensity, curvature, or light deviation, where the intensity of wave front is configured such that structures may be absorptive and may locally absorb wave front intensity with a range from 0% to 100%, where the curvature is configured such that the structure may locally modify wave front curvature with a range of +/- 20, 500, or 1000 Diopters, and light deviation is configured such that the structure may locally scatter light with angle ranging from +/- 1° to +/- 30°. A distance between structures may range from 0 (contiguous) to 3 times the structure (separate microstructures).

A microstructure on a mold or on an insert can be used to mold, for example, a refractive micro-structure and/or a diffractive micro/nano-structure. Microstructures on a mold or an insert can be an inversion of a desired final pattern to be formed on a resulting lens after molding.

Micrometer-sized areas of a curved surface are areas having a contour shape being inscribable in a circle having a diameter greater than or equal to 0.5 micrometers ($\mu$m) and smaller than or equal to 2.0 millimeters (mm).

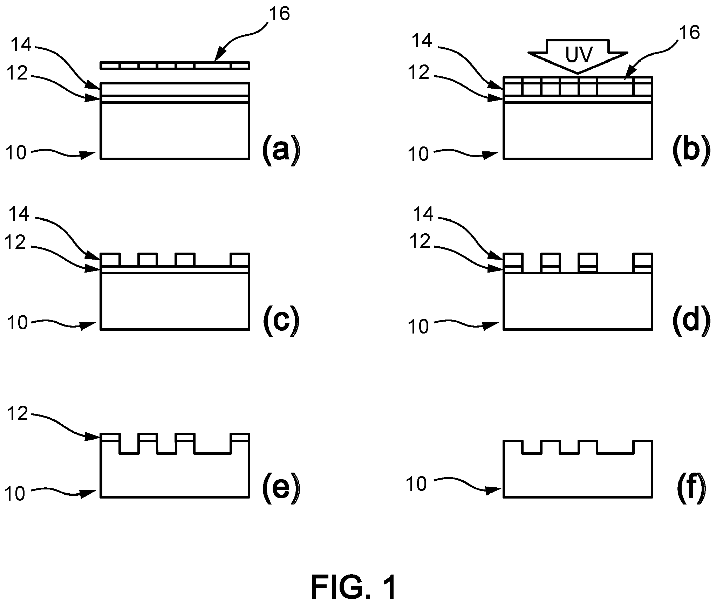

It is now referred to FIG. 1A through 1F, which are simple illustrations of a photolithography process to generate rectangular microstructures on a substrate. Wafer-based semiconductor manufacturing technologies such as photolithography, resist processing and reactive ion etching are shown to allow a very accurate shaping and a precise positioning of a surface profile.

A stack is provided with essentially three layers being a substrate (10) such as a fused silica substrate, a coating (12) such as a chromed layer covering the substrate and a photoresist (14) covering the coating.

As shown on FIG. 1A, a binary photomask (16) is placed over or on the photoresist, then as shown on FIG. 1B areas of the photoresist are exposed to UV light through the photomask. A developer is then applied on the photoresist. As a result, the areas that were exposed to UV light dissolve as shown on FIG. 1C, revealing the coating beneath.

Once the pattern on the photomask is successfully transferred to the stack by revealing corresponding areas of the coating, it is possible to apply known chemical and/or mechanical etching techniques, for instance reactive ion etching, in order to further transfer the pattern to the substrate. For instance, it is possible to, first, etch the revealed areas of the coating to expose the substrate beneath as shown on FIG. 1D, then, etch the exposed areas of the substrate to form the desired rectangular microstructures in the substrate as shown on FIG. IE, and, finally, remove any remaining coating material to only keep the substrate with the transferred surface microstructures as shown on FIG. 1F.

For more complex microstructures such as microlenses, prisms, Fresnel lenses, it is necessary to form a gradient structure in the photoresist before transferring this gradient structure to the substrate by etching, for instance by reactive ion etching. This is possible by using a plurality of binary masks, i.e. by repeating the acts shown in FIG. 1A and FIG. 1B with different binary masks provided successively, but this approach is time-consuming. In practice, grayscale lithography (GSL) is preferred due to enabling a one-step lithography process for the formation of a gradient structure in the photoresist.

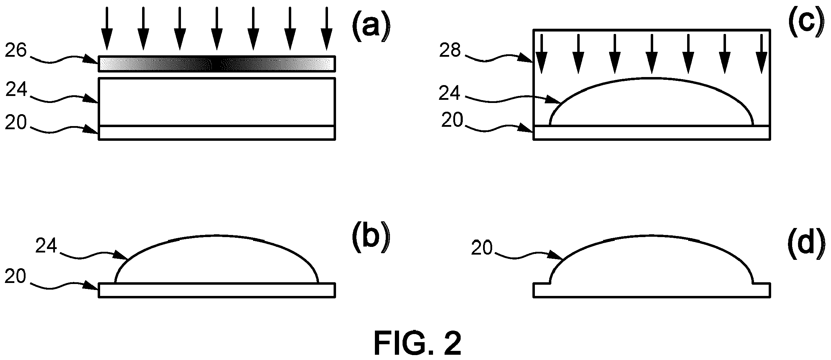

It is now referred to FIG. 2A - 2D, which are simple illustrations of a grayscale lithography process to generate a gradient microstructure on a substrate, as redrawn based on Non-patent document 1.

A photoresist layer (24) covering a substrate (20) is exposed to UV light through an optically graded grayscale mask (26) associated to a desired gradient microstructure, as shown on FIG. 2A. After exposure and development as shown on FIG. 2B, part of the photoresist layer is dissolved and the surface of the photoresist layer has a 3D profile corresponding to the desired gradient microstructure. The desired gradient microstructure may then be transferred to the substrate as shown on FIG. 2C, for instance by reactive ion etching using one or more etching agents (28). After etching the substrate and removing all remaining photoresist, the desired gradient microstructure is achieved at the surface of the substrate as shown on FIG. 2D.

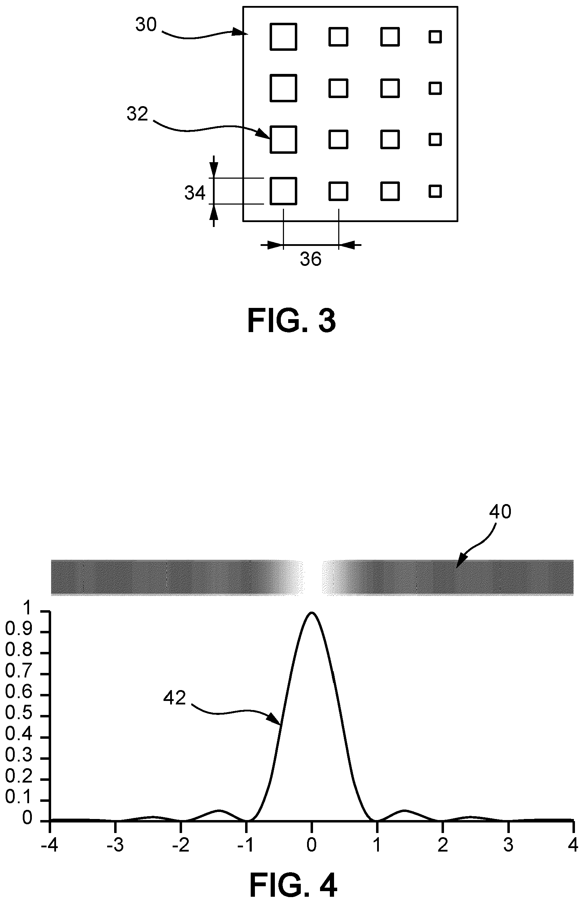

One of the main techniques for manufacturing a grayscale optical mask is manufacturing a conventional chrome on glass (COG) binary mask (30), as illustrated on FIG. 3, which contains sub-resolution opaque pixels (32) which induce diffraction. Diffraction occurs in projection lithography using a COG mask patterned with opaque pixels when both the size (34) and the pitch (36) of the pixels are close to or below the resolution of the projection lithography system.

In typical projection lithography systems that are used nowadays in the semiconductor industry, light is projected through a patterned mask. With the pattern encoded in the light, a reduction lens system shrinks and focuses the pattern onto a photosensitive surface of a wafer. After the pattern is printed, the system moves the wafer slightly and makes another copy of the blueprint.

With a binary mask having sub-resolution opaque pixels, the superimposition of the wavefronts of the light scattered by the sub resolution opaque pixels allows illuminating different target areas on the photosensitive surface with different, non-zero, target exposure doses. FIG. 4 shows a single-slit diffraction pattern (40) with a corresponding intensity diagram (42). As shown in FIG. 4, light diffracted by a sub-resolution pixel breaks up into spatial diffraction orders (0, +1, -1, +2, -2, +3, -3, etc.) forming a diffraction pattern. The resolution of a lithography system is limited by the wavelength of the light that is used and by the ability of the reduction lens system to capture enough diffraction orders from the illuminated mask.

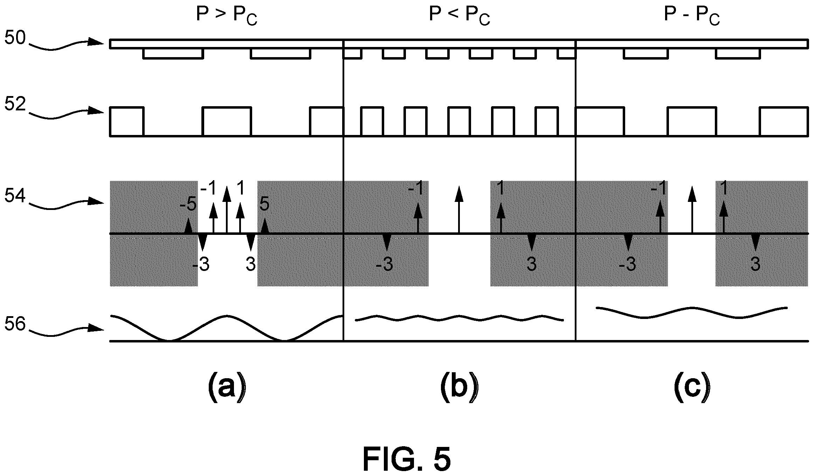

The reduction lens system (54) collects one or more of the spatial diffraction orders in the diffraction pattern (52), according to its numerical aperture, and allows reconstructing the pixels of the binary mask (50) in an aerial image (56) projected towards the photosensitive surface if at least the 0 and one of the first (+1 or -1) order of diffraction orders are collected, as shown on FIG. 5A. However, when the size and pitch of the pixels are small enough, only the 0 order is collected by the reduction lens system and focused onto the photosensitive surface, as shown on FIG. 5B.

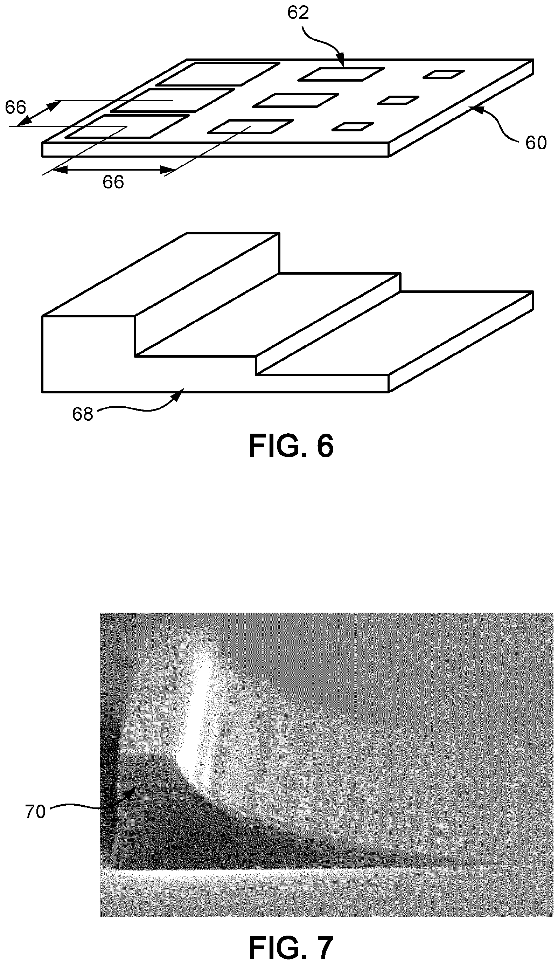

The intensity passing through the mask is dependent on the fill area of each pitch. For example, as shown in FIG. 6, if a mask (60) is designed with square pixels (62) and a set pitch (66) between said pixels, then the intensity of light passing through the objective lens and projected towards a photosensitive surface (68) depends on the percentage of the opaque area for each pitch area. When the pitch is chosen to be below the resolution of the projection system, the distance between each pixel remains below resolution. An easy way to modulate the intensity of light passing through the objective lens is to keep pitch constant and to modulate pixel size. Other applicable methods include keeping the size of the pixel constant and modulating only the pitch, or modulating both the size and the pitch. The number of gray levels is dependent on the resolution and magnification of the projection lithography system, along with the minimal pixel size and increment between subsequent pixel sizes. The number of gray levels determines the roughness or exact definition of the profile in the photoresist.

There is a resolution limit on the minimum pixel size for a given projection lithography system, which sets the upper limit for the area and spacing on the mask. Due to the diagonal spacing between two pixels being the largest spacing, an approximation of the minimum pixel size can be shown by the equation

$$W_{min} = P - \sqrt{\frac{P_C^2}{2}}$$

where $W_{min}$ is the minimum pixel width, P the pitch chosen for the mask and Pc the resolution of the lithography system.

For instance, when the resolution of the lithography system is 3.5 $\mu$m and the pitch is set to 3.5 $\mu$m, then minimum pixel width is about 1 $\mu$m.

If the size of a pixel is below the minimum pixel width defined above, light diffracted by this pixel has maximal intensity. Maximum pixel size is up to the pitch size. It is possible to pattern the mask by modulating pixel size in between these minimum and maximum values.

The maximum value of pixel size is associated to a maximum intensity of diffracted light. This maximum intensity may be chosen to cause, for instance, a full degradation of a positive photoresist placed after the mask, while any intermediate value of pixel size is associated to an intermediate intensity of diffracted light, or "gray level", that causes only a partial degradation of the positive photoresist. As a result, after development, a gray-scale microstructure corresponding to the mask pattern is formed on the positive photoresist. The same principle may be applied to a negative photoresist that is fully or partially strengthened depending on the intensity of diffracted light illuminating areas of the negative photoresist.

The heights of the gray levels depend on many factors, primarily the initial photoresist thickness, the aerial image intensity for each gray level, the absorption coefficient which gives the concentration of both the photoactive compound remaining and exposure product produced, the time of development and the contrast of the photoresist. So, a calibration mask with multiple gray-scale patterns of different pitches and with all available pixels can be used to find both design limits & thickness.

Pixel pitch can also be modulated in order to control the size of the pattern encoded in the light transmitted by the mask when placed in a projection lithography system. However, when the pitch is slightly above the resolution of the projection lithography system, oscillations in the aerial image intensity may occur as shown on FIG. 5C.

FIG. 7 shows an example of an AZ®P4620 photoresist (70) which initially was 5 $\mu$m thick and 25 $\mu$m long, and that has been first illuminated by light diffracted by pixels of a mask and then developed.

The arrangement of pixels on this mask is as following. The pitch is uniformly equal to 3.5 $\mu$m. The pixels are arranged in 30 rows with one row per pixel size. The smallest pixel size is 0.4 $\mu$m with a 0.1 $\mu$m consecutive increment size between the pixels of consecutive rows up to 3.3 $\mu$m. As can be seen, below a pixel width threshold that is about 1 $\mu$m, the photoresist is fully developed.

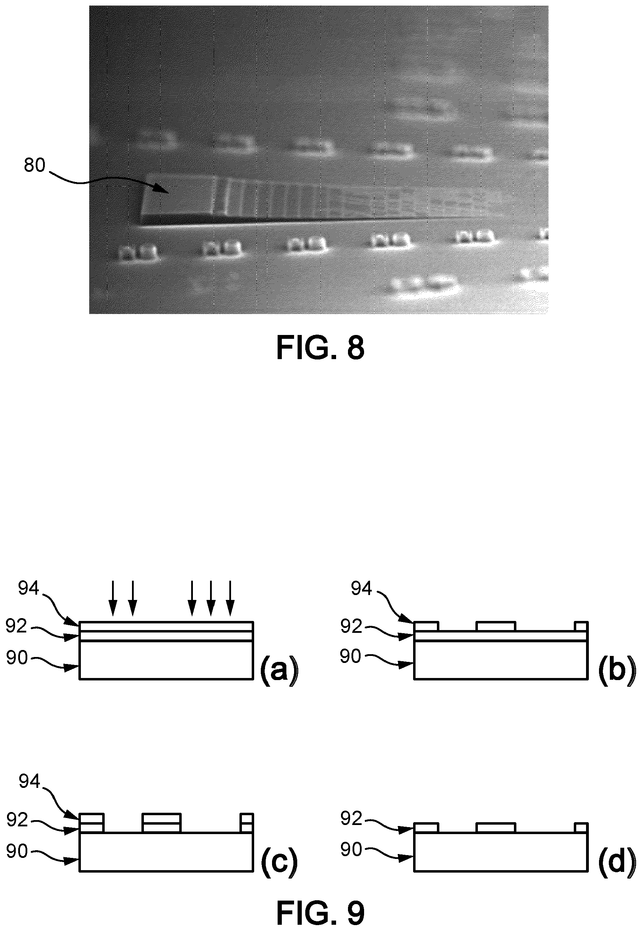

FIG. 8 shows another example of an AZ®P4620 photoresist (80) that has been first illuminated by light diffracted by pixels of another mask and then developed. The arrangement of pixels on this other mask is as following: a uniform 3.5 $\mu$m pitch, 220 rows of pixels with 10 rows per pixel size.

Photomasks may be manufactured using a process similar to the photolithography process already described in FIG. 1A - 1F for generating microstructures on a substrate. The main difference is the exposure of the photoresist which is typically done by electron beams in the case of manufacturing photomasks and by light beams in the case of the photolithography process. FIG. 9A - 9D are graphic illustrations of a chrome-on-glass photomask fabrication process.

A photomask blank comprising a transparent substrate (90) with a chrome opaque coating (92) and a resist (94) is provided. Electron or laser beams illuminate specific areas of the resist to form a pattern, as shown on FIG. 9A. Developing the resist reveals specific areas of the chrome coating, as shown on FIG. 9B. The revealed areas are etched, as shown on FIG. 9C then the remaining photoresist is removed , as shown on FIG. 9D. The end result is a chrome-on-glass photomask, the chrome coating forming opaque pixels on the otherwise transparent surface of the substrate.

The key to greyscale photolithography based on a COG binary mask is to code a specific 3D profile into a dots density pattern, which can be done with the aids of a computer software. The pattern is then written into the photoresist with an electron beam or a laser beam to form a COG photomask using the process described above.

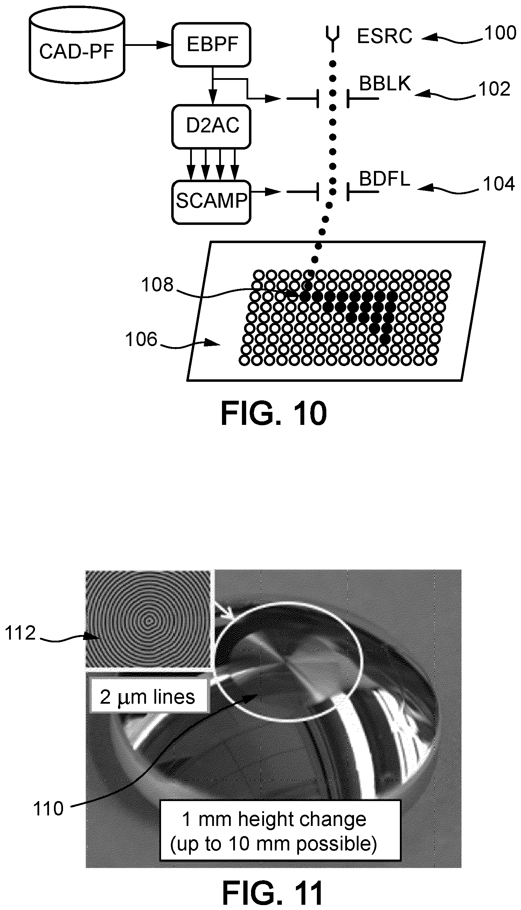

FIG. 10 illustrates schematically an electron beam lithography system that may be used for patterning a commonly used flat COG. A photoresist coated COG piece (106) is first mounted on an X-Y linear motorized stage. In operation, the system:

- sets a beam position to the location of the first desired exposed pixel (108) of a shape,
- using a beam blanker (102), "unblanks" a beam emitted by an electron source (100), that is, starts hitting the photoresist with electrons,
- pauses or dwells for a defined period of time to fully expose the resist at that pixel location,
- using a beam deflector (104) to reposition the beam and/or using motors of the motorized stage to reposition the photoresist coated COG piece, steps to the next pixel in the shape, and pauses to expose that pixel,
- repeats the previous two steps for every exposed pixel in the shape, and
- using the beam blanker, "blanks" the beam, that is, stops exposing the sample, so that the beam can then be re-positioned at the starting pixel of the next shape to be exposed.

The beam blanker may be controlled for example by signals output by an electron beam pattern generator using a dots density pattern provided for instance in the form of a CAD pattern file. Further, the beam deflector may be controlled by a scan amplifier receiving analog signals obtained by converting digital signals output by the electron-beam pattern generator.

A curved COG can be easily produced through typical glass shaping and chrome coating processes. However, generating specific patterns on a curved COG surface is far more challenging than patterning a flat one. A similar electron beam lithography system having an X-Y stage with Z height travel (or X-Y-Z stage) coupled with precise surface mapping is needed. The working principle is similar to 3D printing. A Raith EBPG5200 electron beam lithography system has been used by Penn State University (PSU) researchers to generate 2 $\mu$m wide concentric lines (112) on a curved surface (110), as shown on FIG. 11, as redrawn based on Non-patent document 2.

Although manufacturing a conventional chrome on glass (COG) binary mask with sub-resolution pixels is a possible technique for manufacturing an optical mask that is suitable to transfer a grayscale pattern on a photoresist surface, an alternate technique is to manufacture a "true" grayscale mask, that is, a mask that is divisible in regions, with adjacent regions having different absorbance values.

To do so, a possibility is to manufacture an all-glass photomask from a high energy beam sensitive (HEBS) glass piece which transmission is locally modified using an electron beam pattern generator or a laser beam pattern generator. The mask pattern may be written within a surface glass layer of the all-glass photomask.

HEBS glass is a photosensitive glass that is made from a base glass that is for instance a low expansion zinc-borosilicate glass, also called white crown glass. The base glass can be produced from glass melting just like conventional white crown optical glasses. After the glass is melted, drawn, ground and polished, the base glass plates are ion-exchanged in an acidic aqueous solution containing soluble ionic silver. The ionexchange process is carried out at temperatures in excess of 320°C for a duration sufficient to cause silver ions to diffuse into the glass plates forming a layer that is about 3 $\mu$m wide and contains silver-alkali-halide $(AgX)_m(MX)_n$ complex crystals. HEBS glass may be darkened upon exposure of high energy particles, either electrons or ions, due to the chemical reduction of silver ions in the silver-alkali-halide complex crystals producing colored specks of silver atoms. The transparency of the photosensitive glass is a function of exposure dose. The higher the exposure dose, the darker it becomes. Therefore a continuous variation of exposure dose, for instance, generates a continuous variation of optical intensity of the mask.

Likewise, HEBS glasses may be formed into various curves using typical glass forming and shaping processes. A curved gray scale photomask may be generated from using a curved HEBS glass with the above-mentioned Raith EBPG5200 electron beam lithography system.

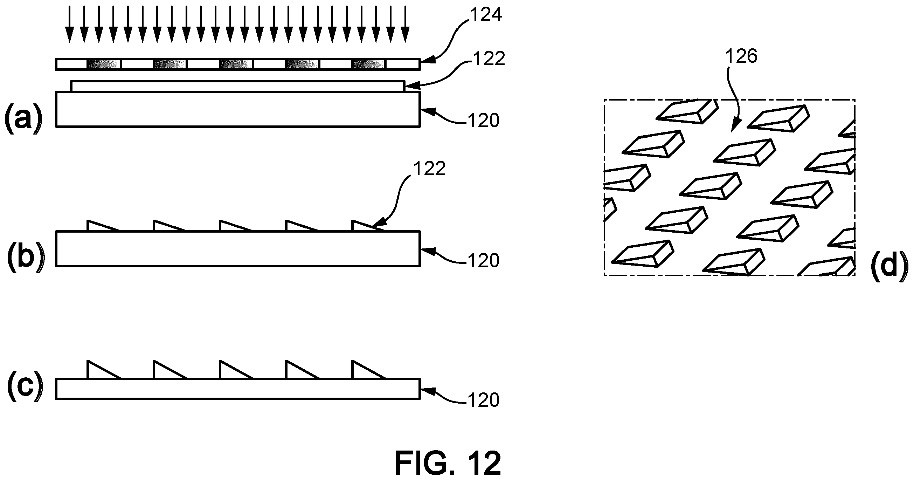

FIG. 12A - 12D show a prism array (126) generated by a gray scale lithography process using a substrate (120) covered with a photoresist layer (122) illuminated through a flat HEBS glass mask (124), as redrawn based on Non-patent document 3. Prisms with sags ranging from 6 to 20 $\mu$m with a base area of 100 $\mu$m $\times$ 100 $\mu$m were fabricated.

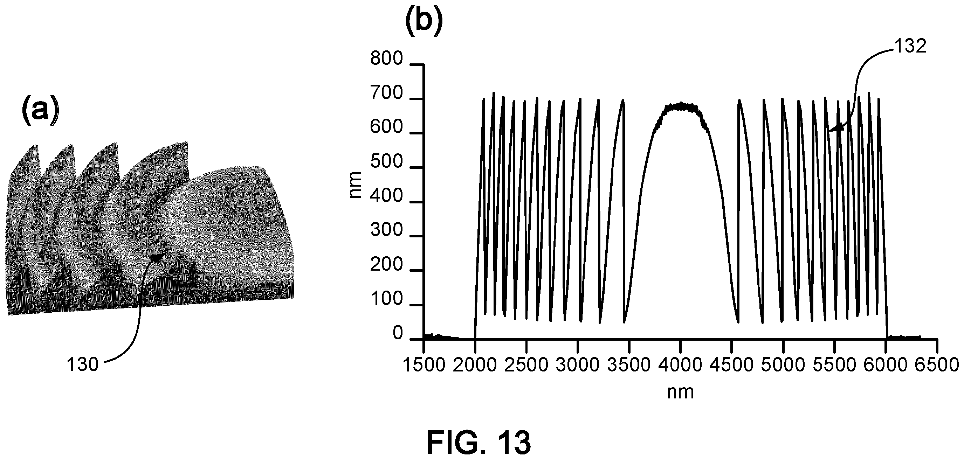

FIG. 13A and 13B show a 600nm Fresnel lens (130) and a corresponding height profile (132), the Fresnel lens having been produced by a gray scale lithography process, as redrawn based on Non-patent document 4.

Of course, there are many types of microstructures other than the above examples that can be generated by photolithography. Using such proven technologies, inserts and molds with complex surface microstructures can be made precisely. However, there is one particular challenge using photolithography to produce microstructures on a curved insert or mold surface, that is, to ensure all resulting microstructures being uniformly normal to the surface. This problem may be addressed by using a photomask having a shape closely matching the target surface.

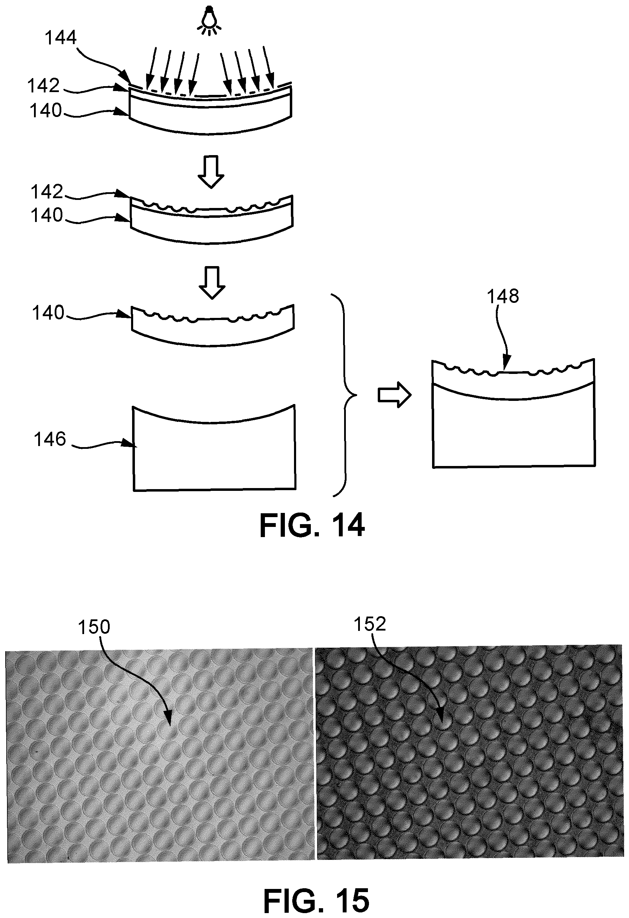

FIG. 14 illustrates a process for producing an insert or a mold having a curved surface with surface microstructures.

At first, a wafer (140) with a curved surface is provided. The wafer may be an all-glass wafer made out of a photosensitive glass or may comprise any transparent substrate and one or more layers including a photoresist (142) on the curved surface. The photoresist may be deposited on the curved surface by spin coating or by any other suitable known process.

The microstructures are then formed on the surface of the curved wafer through photolithography using a curved mask (144) followed by etching. More precisely, when the wafer comprises a photoresist, a developer is applied onto the photoresist and etching such as reactive ion etching enables transferring the pattern onto the substrate. When on the contrary the wafer is made out of photosensitive glass, the areas that have been exposed and have become tinted may also be etched away by known etching techniques.

The key for forming desired microstructures on the substrate that are normal to the curved surface of the wafer is to use a curved mask having a shape conforming to the curved surface of the wafer.

The use of the term "conforming" means that the mask and the curved surface of the wafer may be put one against the other with a space in between being lower than a given threshold, for instance lower than 0.1 mm, at all points.

The photomask may be a rigid glass mask as mentioned above having a surface profile matching the target surface. It may also be a mask made out of a soft material, for example a polymeric material such as PDMS, and that either originally has the same shape as the curved surface of the wafer surface or is adapted to conform to said surface upon contact.

The photomask must be in close proximity (e.g. < 0.1 mm) of the curved surface of the wafer, or in direct contact, to guarantee the resulting microstructures being normal to the target surface.

Afterwards, the curved wafer may be bonded to a base (146), for instance a stainless steel base, to form a composite insert (148) having microstructures on the surface using a process similar to typical glass-bond inserts being used for injection molding of finished single vision polycarbonate lenses. Alternatively, the curved wafer with surface microstructures may be used as is to be a mold for casting thermoset lenses.

One additional benefit of using fused silica or photosensitive glass inserts for injection molding is the ability to produce finished single vision polycarbonate lenses with microstructures and without weld line and center distortion defects, owing to the low thermal conductivity of such inserts, that is very close to the thermal conductivity of borosilicate crown glass.

Besides making an insert for injection molding or using it as a mold for casting, the microstructured wafer may be used as a master to produce a stamp using soft polymeric materials such as PDMS. The stamp, which is typically much cheaper than a photomask, can then be used to produce additional microstructured silicon wafers through imprinting lithography.

Injection molding of PC lenses using an insert with a microlens array on a fused silica substrate bonded to a stainless steel base has been conducted. In this example, each microlens is a hemisphere with a diameter of about 100 $\mu$m. The pitch between adjacent microlenses is also uniform and about 110 $\mu$m. As shown on FIG. 15, a microlens array has been transferred successfully from an insert (152) to a molded polycarbonate lens surface (150).

To all intents and purposes, the following non-patent literature is cited.

Non-patent document 1: Scrymgeour, David, Kemme, Shanalyn A., Boye, Robert R., Ellis, A. Robert, Carter, Tony Ray, Samora, Sally, and Hunker, Jeffrey D. 2013. "Micro-optical grayscale excitation lenses for atom and ion trapping.". United States. https://www.osti.gov/servlets/purl/1297085.

Non-patent document 2: https://www.mri.psu.edu/nanofabrication-lab/capabilities/lithography/electron-beam-lithography-0.

Non-patent document 3: Christiane Gimkiewicz, Detlev Hagedorn, Jürgen Jahns, Ernst-Bernhard Kley, and Frank Thoma, "Fabrication of microprisms for planar optical interconnections by use of analog grayscale lithography with high-energy-beam-sensitive glass," Appl. Opt. 38, 2986-2990 (1999) https://opg.optica.org/ao/abstract.cfm?URI=ao-38-14-2986.

Non-patent document 4: Nachmias, Tali & Ohayon, Avi & Meltzer, Shefer & Kabla, Meni & Louzon, Elie & Levy, Uriel. (2009). Shallow Fresnel lens fabrication using grayscale lithography made by high energy beam sensitive mask (HEBS) technology and reactive ion etching. Proceedings of SPIE - The International Society for Optical Engineering. 7205. 10.1117/12.809376.

## Claims

**1.** A method for patterning a mask having a curved surface by causing local variations of an optical property over the curved surface, wherein:

the method comprises illuminating selected micrometer-sized areas of the curved surface; and the curved surface is made of a material which, when thusly illuminated, undergoes local transformations over the illuminated areas, the local transformation being related to the local variations of the optical property.

2. The method of claim 1,

wherein illuminating the selected micrometer-sized areas of the curved surface comprises, for each selected micrometer-sized area, displacing the mask so that the selected micrometer-sized area is in a set X-Y-Z position and illuminating the set X-Y-Z position.

3. The method of claim 1 or 2, wherein the material of the curved surface is a photoresist.

4. The method of claim 3, wherein the method further comprises:

after illuminating the selected micrometer-sized areas of the curved surface, locally dissolving the material of the curved surface to locally reveal a coating, for example by applying a developer; and,

optionally, after locally dissolving the material of the curved surface, etching the revealed coating, for example by reactive ion etching.

5. The method of claim 1 or 2, wherein the material of the curved surface is a high energy beam sensitive glass.

6. The method of claim 5, wherein illuminating the selected micrometer-sized areas of the curved surface comprises illuminating a first selected micrometer-sized area with a first exposure dose and illuminating a second selected micrometer-sized area with a second exposure dose different from the first exposure dose.

7. A method for preparing an object having a curved surface to be etched, the resulting etched surface being useable as a mold for manufacturing an optical article, wherein:

the method comprises illuminating the curved surface of the object through a patterned mask placed over or on the curved surface;

the patterned mask comprises a curved surface that is configured to conform to the curved surface of the object;

the curved surface of the patterned mask comprises at least one micrometer-sized area that differs in transmission function from an adjacent area; and

the curved surface is made of a material which, when thusly illuminated, undergoes local changes in a chemical resistance to a developer.

8. The method of claim 7, wherein the patterned mask is a binary mask, for example a chrome on glass binary mask.

9. The method of claim 8, wherein:

the curved surface of the binary mask comprises a plurality of micrometer-sized areas that differ in transmission function from an adjacent area, said micrometer-sized areas being arranged according to a pattern comprising a first region with a first density of said micrometer-sized areas and a second region with a second density of said micrometer-sized areas different from the first density.

10. The method of claim 7, wherein the patterned mask is a gray-scale mask, for example a gray-scale high energy beam sensitive glass mask.

11. The method of claim 10, wherein the curved surface of the gray-scale mask comprises a first region with a first transmittance and a second region with a second transmittance different from the first transmittance.

12. The method of claim 9 or 11, wherein illuminating the curved surface of the object through the patterned mask comprises:

illuminating a first region of the curved surface of the object through the first region of the curved surface of the patterned mask, so that the first region of the curved surface of the object receives a first exposure dose; and

illuminating a second region of the curved surface of the object through the second region of the curved surface of the patterned mask, so that the second region of the curved surface of the object receives a second exposure dose different from the first exposure dose.

13. An optical article having a curved surface comprising microstructures;

wherein the microstructures are uniformly normal to the curved surface.

14. An optical article according to claim 13, for use in slowing down myopia progression.

15. An optical article according to claim 13 or 14, wherein the optical article is weld-line free.

FIG. 1

FIG. 2

EP 4 335 630 A1

30

32

34

36

**FIG. 3**

40

42

-4   -3   -2   -1   0   1   2   3   4

**FIG. 4**

FIG. 5

FIG. 6

FIG. 7

FIG. 8

FIG. 9

**FIG. 10**

**FIG. 11**

**FIG. 12**

EP 4 335 630 A1

(a)

130

(b)

132

nm

1500 2000 2500 3000 3500 4000 4500 5000 5500 6000 6500
nm

EP 4 335 630 A1

FIG. 13

**FIG. 14**

**FIG. 15**

Europäisches
Patentamt

European
Patent Office

Office européen
des brevets

# EUROPEAN SEARCH REPORT

Application Number

EP 22 30 6329

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/154298 A1 (LIU CHIEN-HSUAN [TW] ET AL) 2 June 2016 (2016-06-02) | 1-4 | INV.<br>B29D11/00 |
| A | * abstract *<br>* figures 5-9 *<br>* paragraphs [0032] – [0036] * | 5-15 | G03F7/18<br>G03F7/24<br>G03F7/20 |
| X | US 6 416 908 B1 (KLOSNER MARC A [US] ET AL) 9 July 2002 (2002-07-09) | 1-4 | |
| Y | * abstract * | 8 | |
| A | * figure 5 *<br>* column 8, line 64 – column 9, line 44 * | 5-7,<br>10-15 | |
| X | US 2005/053844 A1 (WU CHE-KUANG [US]) 10 March 2005 (2005-03-10) | 1-3,5,6 | |
| Y | * abstract * | 10-12 | |
| A | * paragraphs [0012] – [0021], [0100] – [0118], [0416], [0433] – [0446] * | 4,7-9,<br>13-15 | |
| X | US 2013/022764 A1 (CHOU CHING-YU [TW] ET AL) 24 January 2013 (2013-01-24) | 7,13,15 | |
| Y | * abstract * | 8,10-12 | TECHNICAL FIELDS SEARCHED (IPC) |
| A | * figures 1-5 *<br>* paragraphs [0016] – [0018] * | 1-6,9,14 | B29D<br>G03F |
| X | US 2021/387430 A1 (TOYOSHIMA YOSHIAKI [JP]) 16 December 2021 (2021-12-16) | 13-15 | |
| A | * abstract *<br>* figures 1-10 *<br>* page 30, line 22 – page 31, line 8 * | 1-12 | |
| X | WO 2022/031298 A1 (ZEISS CARL VISION INT GMBH [DE]; SPRATT RAY STEVEN [US]) 10 February 2022 (2022-02-10) | 13-15 | |
| A | * abstract *<br>* figures 7-10 *<br>* page 30, line 21 – page 31, line 5 * | 1-12 | |

-/--

The present search report has been drawn up for all claims

| Place of search | Date of completion of the search | Examiner |
|---|---|---|
| The Hague | 27 March 2023 | Heckmann, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 22 30 6329

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/175860 A1 (LIU XINBING [US]) 2 August 2007 (2007-08-02) | 1-3,13, 15 | |
| A | * abstract *<br>* figures 1-7 *<br>* paragraphs [0017] – [0019], [0025] – [0034] * | 4-12,14 | |

-----

**TECHNICAL FIELDS SEARCHED (IPC)**

The present search report has been drawn up for all claims

| Place of search | Date of completion of the search | Examiner |
|---|---|---|
| The Hague | 27 March 2023 | Heckmann, Paul |

EPO FORM 1503 03.82 (P04C01)

Europäisches
Patentamt

European
Patent Office

Office européen
des brevets

Application Number

EP 22 30 6329

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

1. claims: 1-6

   A method for patterning a mask having a curved surface by causing local variations of an optical property over the curved surface.
   ---

2. claims: 7-15

   A method for preparing an object having a curved surface to be etched, the resulting etched surface being useable as a mold for manufacturing an optical article.
   or
   An optical article having a curved surface comprising microstructures; wherein the microstructures are uniformly normal to the curved surface.
   ---

## ANNEX TO THE EUROPEAN SEARCH REPORT
## ON EUROPEAN PATENT APPLICATION NO.

EP 22 30 6329

This annex lists the patent family members relating to the patent documents cited in the above-mentioned European search report.
The members are as contained in the European Patent Office EDP file on
The European Patent Office is in no way liable for these particulars which are merely given for the purpose of information.

27-03-2023

| Patent document cited in search report | | Publication date | Patent family member(s) | | Publication date |
|---|---|---|---|---|---|
| US 2016154298 | A1 | 02-06-2016 | CN | 103309168 A | 18-09-2013 |
| | | | TW | 201337475 A | 16-09-2013 |
| | | | US | 2013244139 A1 | 19-09-2013 |
| | | | US | 2014333914 A1 | 13-11-2014 |
| | | | US | 2016154298 A1 | 02-06-2016 |
| US 6416908 | B1 | 09-07-2002 | NONE | | |
| US 2005053844 | A1 | 10-03-2005 | US | 6524756 B1 | 25-02-2003 |
| | | | US | 2002019305 A1 | 14-02-2002 |
| | | | US | 2005053844 A1 | 10-03-2005 |
| US 2013022764 | A1 | 24-01-2013 | TW | 201306689 A | 01-02-2013 |
| | | | US | 2013022764 A1 | 24-01-2013 |
| US 2021387430 | A1 | 16-12-2021 | CN | 111629876 A | 04-09-2020 |
| | | | EP | 3730269 A1 | 28-10-2020 |
| | | | JP | 7216667 B2 | 01-02-2023 |
| | | | JP | WO2019124354 A1 | 25-02-2021 |
| | | | US | 2021387430 A1 | 16-12-2021 |
| | | | WO | 2019124354 A1 | 27-06-2019 |
| WO 2022031298 | A1 | 10-02-2022 | WO | 2022029031 A1 | 10-02-2022 |
| | | | WO | 2022031298 A1 | 10-02-2022 |
| US 2007175860 | A1 | 02-08-2007 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2021109379 A

### Non-patent literature cited in the description

- **SCRYMGEOUR, DAVID, KEMME ; SHANALYN A. ; BOYE, ROBERT R. ; ELLIS, A. ROBERT ; CARTER, TONY RAY ; SAMORA, SALLY ; HUNKER, JEFFREY D.** *Micro-optical grayscale excitation lenses for atom and ion trapping.". United States,* 2013, https://www.osti.gov/servlets/purl/1297085
- **CHRISTIANE GIMKIEWICZ ; DETLEV HAGEDORN ; JÜRGEN JAHNS ; ERNST-BERNHARD KLEY ; FRANK THOMA.** Fabrication of microprisms for planar optical interconnections by use of analog gray-scale lithography with high-energy-beam-sensitive glass. *Appl. Opt.,* 1999, vol. 38, 2986-2990, https://opg.optica.org/ao/abstract.cfm?URI=ao-38-14-2986
- **NACHMIAS, TALI ; OHAYON, AVI ; MELTZER, SHEFER ; KABLA, MENI ; LOUZON, ELIE ; LEVY, URIEL.** Shallow Fresnel lens fabrication using grayscale lithography made by high energy beam sensitive mask (HEBS) technology and reactive ion etching. *Proceedings of SPIE - The International Society for Optical Engineering,* 2009, 7205